(19) **Europäisches Patentamt**

**European Patent Office**

**Office européen des brevets**

(11) **EP 1 079 004 A2**

(12) **EUROPEAN PATENT APPLICATION**

(43) Date of publication:
**28.02.2001 Bulletin 2001/09**

(51) Int Cl.$^7$: **C23F 4/00**

(21) Application number: **00307100.8**

(22) Date of filing: **18.08.2000**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI**<br><br>(30) Priority: **20.08.1999 US 378409**<br><br>(71) Applicant: **APPLIED KOMATSU TECHNOLOGY, INC.**<br>**Shinjuku, Tokyo (JP)** | (72) Inventors:<br>• **Wang, Kai-An**<br>  **Cupertino, California 95014 (US)**<br>• **Wu, Tzy-Chung**<br>  **Palo Alto, California 94303 (US)**<br>• **Goto, Haruhiro H.**<br>  **Saratoga, California 95070 (US)**<br><br>(74) Representative: **Allard, Susan Joyce et al**<br>**BOULT WADE TENNANT,**<br>**Verulam Gardens**<br>**70 Gray's Inn Road**<br>**London WC1X 8BT (GB)** |

(54) **Aluminium-neodymium etch process with hydrogen iodide**

(57)     A method of etching an alloy of aluminium and neodymium by exposing the alloy to a plasma formed from a gas mixture of chlorine and hydrogen iodide (HI). The hydrogen iodide etches the neodymium component of the alloy, and the chlorine etches the aluminium component. Preferably, the gas mixture further includes $BCl_3$ to provide sputter etching by boron ions.

FIG._1

**Description**

This invention relates to plasma etch processes used in the manufacture of electronic devices such as liquid crystal displays and integrated circuits. More specifically, the invention relates to processes for etching interconnect lines composed of aluminum-neodymium alloy.

Aluminum is the most commonly used material for fabricating interconnect lines in thin film transistor liquid crystal displays and in integrated circuits on silicon wafers. Instead of using pure aluminum, it has been proposed to form the interconnect lines of an alloy of aluminum and a small percentage of neodymium in order to minimize the formation of hillocks in the lines.

One obstacle to the use of aluminum-neodymium alloy is the difficulty of etching the neodymium component. Conventional plasma processes for etching aluminum, such as those based on $BCl_3$ and $Cl_2$ gas mixtures, do not effectively etch neodymium, so that neodymium residue remains after the aluminum has been completely etched.

Therefore, a need exists for a plasma etch process that effectively etches aluminum-neodymium alloys.

The present invention is a process and apparatus for etching an alloy of aluminum and neodymium using a plasma formed from a gas mixture of chlorine and hydrogen iodide (HI). The hydrogen iodide is especially effective at etching the neodymium component of the alloy, and the chlorine is especially effective at etching the aluminum component. Preferably, the gas mixture further includes $BCl_3$ to provide sputter etching by boron ions.

Tests of our preferred embodiments of the etching process produced metal features having desirably smooth side wall surfaces. Additionally, we could control the taper of the side wall to achieve a desired angle between the side wall and the plane of the top or base of the metal features. We also found that our preferred etching process did not leave any corrosive residue.

The following drawings are provided by way of example.

Figures 1-4 are sectional views of a substrate showing various stages of etching using the process of the present invention.

Figure 1 shows the final stage after removal of the photoresist.

Figure 2 shows the initial stage before etching.

Figure 3 shows the substrate after etching of the metal film, before removal of the photoresist.

Figure 4 shows the same stage as Figure 3, but with undercutting of the metal film due to insufficient HI.

Figure 5 is a schematic side view of a plasma chamber suitable for performing the etch process of the invention.

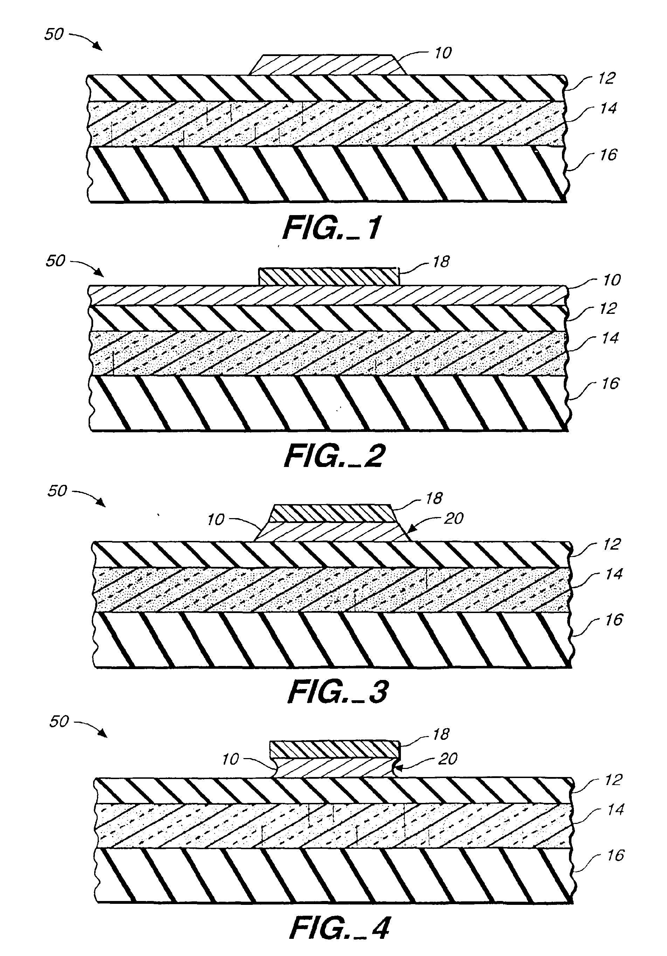

The present invention is a process and apparatus for etching an alloy of aluminum and neodymium. To illustrate a practical application of the invention, Figure 1 shows the structure of a conventional electronic device or workpiece that could be fabricated using the invention. Specifically, Figure 1 illustrates an electronic device or workpiece 50 on which a metal interconnect line 10 has just been fabricated. The interconnect line 10 extends perpendicular to the drawing page and typically functions to electrically connect together two components of the electronic device. In the exemplary device, the interconnect line overlies a dielectric layer 12, which in turn overlies various other layers of electronic devices designated jointly as 14, which in turn overlies a substrate 16.

Etch Chamber Apparatus

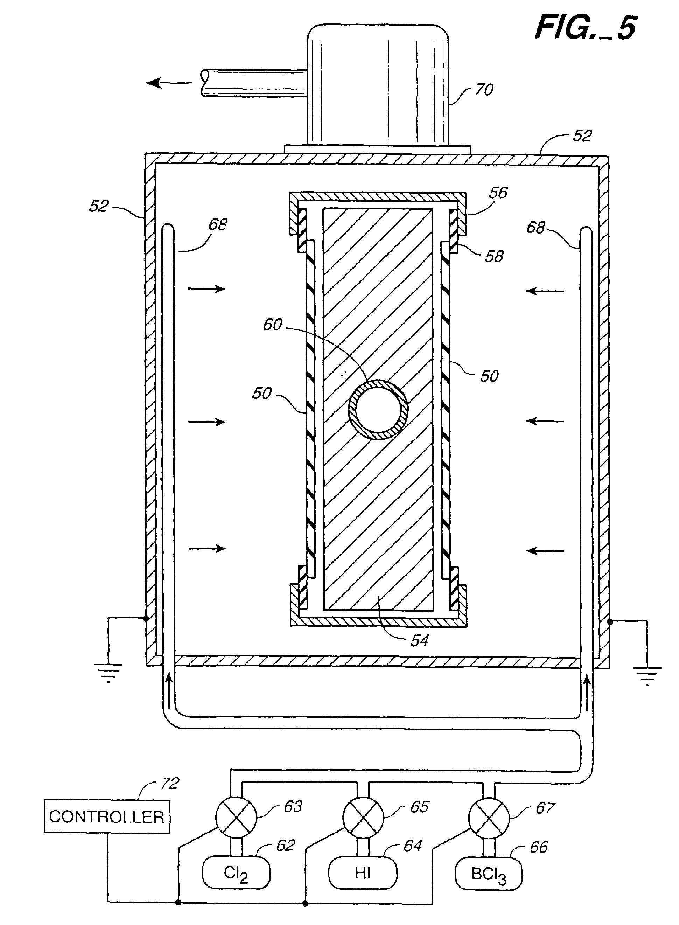

The process of our invention can be performed in any conventional process chamber or vacuum chamber suitable for performing plasma etch processes. Figure 5 shows a plasma etch chamber that is especially adapted for processing large substrates, such as the glass substrates used to manufacture flat panel displays. This etch chamber can etch two workpieces 50 simultaneously. The chamber is described in more detail in commonly-assigned U.S. patents 5,843,277 and 5,895,549 and in commonly-assigned application SN 09/061,013 filed 4/15/98 by Goto, the entire content of each of which is hereby incorporated by reference into this patent specification.

The plasma etch chamber has an interior enclosed by an electrically grounded chamber wall 52 composed of a metal that will not contaminate the etch process, typically anodized aluminum. Two flat, rectangular workpieces or substrates 50 are mounted on opposite sides of a metal cathode electrode 54 by clamps 56. Figure 5 shows each workpiece 50 as extending in a plane that is perpendicular to the page of the figure. Dielectric spacers 58 electrically isolate the workpieces from the clamps. The cathode 54 is mounted on a hollow shaft 60 that rotates to orient the substrates vertically as shown during plasma processing, and to orient the substrates horizontally when they are being transported into and out of the chamber.

Chlorine and hydrogen iodide gases are supplied by first and second gas tanks 62 and 64, respectively. $BCl_3$ gas optionally is supplied by a third gas tank 66. The flow rate of each gas into the chamber interior is controlled by respective flow controllers 63, 65, and 67. The gases flowing from the flow controllers are dispensed into the chamber interior through two gas distribution manifolds 68. Each gas distribution manifold has a planar, rectangular array of gas outlet apertures, the plane of the array being parallel to the adjacent workpiece 50, i.e., perpendicular to the page as depicted in Figure 5. The gases are exhausted from the chamber by pump 70, which includes a throttle valve to regulate the total gas pressure within the chamber. The arrows in Figure 5 illustrate the direction of gas flow.

An RF electrical power supply, not shown, supplies RF power between two output terminals that are ungrounded and grounded, respectively. The ungrounded output terminal is coupled to the cathode electrode 54 via an RF transmission line that extends through the hollow shaft 60. The grounded output terminal is coupled to the chamber wall by virtue of the wall being electrically grounded. Consequently, the RF power flows between the cathode electrode and the chamber wall, which excites the gases within the chamber into a plasma state so as to form a plasma body adjacent each of the two workpieces 50.

An electrical controller 72, preferably a programmable microcomputer, sends electrical signals to the flow controllers to control their respective flow rates. The controller also sends electrical signals to the exhaust throttle valve to control the chamber pressure and to the RF power supply to control the RF power output. The master controller 72 preferably is programmable so that the process parameters such as flow rates, pressures, and power levels can-be adjusted by a human operator.

Process

If the electronic device is a liquid crystal display, the substrate 16 typically would be glass, and the layers 14 of electronic devices typically would include liquid crystal display cells and overlying thin film transistors. If the electronic device is an integrated circuit, the layers 14 typically would include transistors fabricated in a single-crystal silicon substrate 16.

A conventional method of fabricating a metal interconnect line is to deposit a blanket layer of the metal 10 over the dielectric 12 as shown in Figure 2, and to then deposit over the metal a layer of resist 18. The resist is patterned as shown in Figure 2 so that it only covers the portions of the metal layer that are intended to form the interconnect lines. The workpiece then is subjected to a plasma etch process that removes all exposed regions of the metal layer 10, thereby producing the structure shown in Figure 3. Lastly, the resist is removed, leaving the structure shown in Figure 1.

When we state that the etch process removes "exposed" regions of the metal layer, we define "exposed regions" to mean all portions of the metal layer that are not covered by the resist 18. We consider such regions of the metal to be "exposed" even though the exposed surface may be covered by thin layer of native oxide as a result of exposure of the metal to oxygen, such as oxygen in the ambient atmosphere.

As stated in the Background of the Invention, the most commonly used material for interconnect lines 10 is aluminum. Alloying aluminum with a small amount of neodymium would be advantageous for preventing the formation of hillocks in the interconnects, but conventional plasma etch processes prior to our invention could not etch the aluminum-neodymium alloy without leaving an excessive amount of neodymium residue.

Starting with a workpiece having a layer 10 of aluminum-neodymium alloy as shown in Figure 2, our invention can etch the regions of the alloy not covered by resist 18 so as to produce the structure shown in Figure 3. In particular, our invention can be adjusted to etch the aluminum and neodymium at approximately equal rates so as to leave no residue of neodymium when the etch is completed.

The process of our invention is to etch the aluminum-neodymium alloy in a plasma formed from a gas mixture that includes chlorine and hydrogen iodide (HI). Chlorine ions and radicals in the plasma etch the aluminum component of the alloy by reacting with the aluminum to form $AlCl_3$. Iodine ions and radicals in the plasma etch the neodymium component of the alloy by reacting with the neodymium to form $NdI_3$. The $AlCl_3$ and $NdI_3$ reaction products are both volatile and are readily exhausted from the process chamber by exhaust pump 70.

If the aluminum-neodymium alloy were etched using a conventional process using chlorine but no hydrogen iodide, chlorine would react with some of the neodymium to form $NdCl_3$. The formation of $NdCl_3$ is highly undesirable because $NdCl_3$ is extremely non-volatile, with a boiling point of about 1600° C. Therefore, most of the $NdCl_3$ will remain on the workpiece, unlike the previously discussed $AlCl_3$ and $NdI_3$ reaction products which readily evaporate so they can be exhausted from the process chamber. One disadvantage of such $NdCl_3$ residue is that it obstructs etching of any underlying aluminum, thereby leaving a rough surface on the etched metal. Another disadvantage is that, because it contains chlorine, the $NdCl_3$ residue will corrode the workpiece unless it is subsequently washed off the workpiece.

In contrast, because our process employs hydrogen iodide, formation of $NdCl_3$ is avoided. Although the scope of our invention is not limited to a specific theory of operation, we believe that supplying sufficient iodine ions in the plasma to react with the neodymium on the workpiece will prevent the formation of $NdCl_3$ because the reaction

$$Nd + 3 Cl^+ \rightarrow NdCl_3$$

requires a greater activation energy than the reaction

$$Nd + 3\,I^{+} \rightarrow NdI_{3}$$

Consequently, our process can be performed without leaving any corrosive residue on the workpiece, so that no subsequent cleaning step is required to avoid corrosion.

The ratio of HI to chlorine in the gas mixture is proportional to the ratio between the respective volumetric flow rates of these gases into the chamber. This ratio preferably should be adjusted (by master controller 72 which controls flow controllers 63, 65) to be high enough to etch the neodymium component of the alloy at a rate approximately equal to, or greater than, the rate at which the aluminum component is etched.

If the ratio of HI flow rate to chlorine flow rate is adjusted too low, the aluminum component of the alloy will finish etching before the neodymium component is finished etching. If the etch process were stopped at that point, undesirable neodymium residue would remain on the workpiece. Conversely, if the etch process were continued beyond that point until all the neodymium was removed, then the chlorine ions would begin to etch the aluminum at the sides 20 of the interconnect lines below the resist, thereby producing a rough surface and, as shown in Figure 4, undesirable undercutting. A sufficiently high ratio of HI flow rate to chlorine flow rate will avoid these undesirable results.

If the chlorine gas flow rate is adjusted too high, regardless of whether the HI flow rate is correspondingly high, we expect the result will be the same as described in the preceding paragraph. The reason relates to the low vapor pressure of $NdI_{3}$, the product of the neodymium etching reaction, so that the slow evaporation rate of $NdI_{3}$ limits the rate at which the neodymium component of the alloy can be etched. If HI is supplied to the chamber at a flow rate in excess of the rate required to achieve this maximum neodymium etch rate, the excess HI will not further increase the etch rate of the neodymium, hence the excess HI simply will be wasted. More importantly, if the maximum etch rate of the neodymium component in the alloy is a certain number of angstroms per minute, than the chlorine gas flow rate preferably should not be in excess of the amount required to etch the aluminum at the same rate. Otherwise, the excess chlorine will produce the same undesirable results as an excessive ratio of chlorine to HI, as described in the preceding paragraph.

Conversely, if the ratio of HI flow rate to chlorine flow rate is somewhat higher than the ratio at which the neodymium and aluminum components of the alloy are etched at the same rate, we do not expect any adverse effect on the quality of the etched features. Because the neodymium concentration in the alloy typically is only a few percent, the neodymium component of the alloy cannot etch any faster than the aluminum component, even in the presence of an excess of HI. The primary consequence of an excess ratio of HI to chlorine merely would be to decrease the concentration of chlorine in the gas mixture, thereby reducing the etch rate of the aluminum. In other words, an excess HI flow rate results in a greater percentage of both HI and chlorine gas that does not react with the alloy, thereby unnecessarily increasing the consumption of these expensive gases.

Therefore, to maximize film quality and to avoid consuming a greater quantity of reagent than necessary, we prefer adjusting the HI gas flow rate to a level not substantially greater than the level required to maximize the etch rate of the neodymium component of the alloy. We prefer adjusting the chlorine gas flow rate to equal or be slightly less than the level at which the etch rate of the aluminum component equals the etch rate, in angstroms per minute, of the neodymium component at the selected HI flow rate. Of course, the quality of the etched features also is strongly affected by other process parameters such as the flow rate of other process gas constituents such as $BCl_{3}$, chamber pressure, substrate temperature, and RF power.

The required ratio of HI to chlorine in the gas mixture is proportional to the ratio of neodymium to aluminum in the alloy 10 to be etched. In testing our process by etching a layer of aluminum alloy composed of 88% wt aluminum, 1% or 2% wt neodymium, and 10% wt silicon, we obtained good results over a broad range of ratios between the $Cl_{2}$ and HI gas flow rates. Specifically, Table 1 below shows good results with such ratios ranging between 3:1 and 1:3. We did not try more extreme ratios, or higher chlorine flow rates, to discover conditions that could produce undesirable film quality.

All of the flow rates and gas ratios described above are controlled by the first and second gas flow controllers 63, 65 in response to commands from the electrical master controller 72.

As in conventional processes for plasma etching of aluminum, before performing the main etching of the metal 10 it typically is necessary to perform a short "break through etch" step to remove native oxide from the surface of the metal. This conventionally is accomplished by sputter etching the workpiece with relatively heavy ions, typically boron ions produced by the plasma decomposition of $BCl_{3}$ gas supplied to the plasma chamber. Typically the the workpiece is mounted atop a cathode electrode that is coupled to an RF power supply through a capacitor that allows a negative DC bias voltage to develop between the cathode and the plasma body. The negative bias voltage accelerates the boron ions to bombard the workpiece. This initial breakthrough etch step can be performed with the chlorine and HI gas supplies turned off.

Conventional plasma etch processes for aluminum typically continue to supply $BCl_{3}$ in the process gas mixture during the main chlorine-based reactive plasma etch process that follows the breakthrough etch step. The $BCl_{3}$ sputter

etches the workpiece, while the chlorine reactively etches the workpiece. Plasma etch processes that include both reactive etching and sputter etching are referred to as reactive ion etching (RIE).

Including $BCl_3$ in the process gas mixture, so as to sputter etch the substrate with boron ions simultaneously with the main $Cl_2$-HI reactive etch process, would be expected to help increase the temperature at the substrate surface, which should help increase the neodymium etch rate by promoting the evaporation of the $NdI_3$ reaction product.

Furthermore, including $BCl_3$ would be expected to provide benefits similar to those it provides in conventional RIE processes: to avoid undercutting of the side wall 20, to shape the side wall with a controlled taper angle, and to scavenge water vapor. Accordingly, our preferred implementation of the etch process includes $BCl_3$ along with chlorine and hydrogen iodide in the process gas mixture, and the cathode electrode is negatively biased as described above.

Including $BCl_3$ avoids undercutting because sputter etching is more vertically directional (anisotropic) than reactive etching. Reactive etching alone can produce undesirable undercutting of the side wall 20 of the metal features, as shown in Figure 4.

In fabricating metal gate electrodes for thin film transistors, such as in liquid crystal displays, it is desirable to shape the side wall 20 of each gate electrode 10 so that it has a 45° taper as shown in Figures 1 and 3, instead of being vertical (zero taper) as in most single crystal silicon integrated circuits. This taper can be achieved by providing enough $BCl_3$ to slowly sputter etch back the edges of the resist 18 while the metal 10 is being etched. Increasing the proportion of $BCl_3$ in the process gas mixture increases the taper angle of the interconnect side walls. (The taper angle is measured relative to the vertical axis, so that a vertical side wall is said to have zero taper.) Similarly, the taper angle of the side wall can be increased by reducing the flow rates of the chlorine and HI gases so as to decrease the metal etch rate relative to the photoresist etch rate.

As in a conventional process for plasma etching of aluminum, it is preferable to cool the cathode assembly 54 on which the workpiece 50 rests to maintain the assembly at a regulated temperature, preferably about 60° to 80° C. This prevents the workpiece from becoming too hot during etching, because workpiece temperatures above 120° can damage typical photoresist materials 18. In the preferred etch chamber shown in Figure 5, cooling fluid such as water is pumped through a conduit within the hollow shaft 60 so that the fluid circulates through channels within the cathode assembly.

Comparative Example — Control

As a control, we tried etching an aluminum-neodymium film using a conventional process for plasma etching of aluminum, performed in a conventional plasma etch chamber. Specifically, we etched 300 x 350 mm glass substrates on which a metal film had been deposited consisting of 89% aluminum, 10% silicon, and 1% neodymium by weight. The chlorine flow rate was 50 sccm, and $BCl_3$ flow rates of both 15 sccm and 50 sccm were tested. The chamber pressure was 7 mTorr. The plasma was capacitively excited by 2000 watts of RF power at a frequency of 13 MHz. The substrate was initially sputter etched by $BCl_3$ for 1 minute before the $Cl_2$ was turned on, for the purpose of removing native oxide from the metal film.

SEM photographs of the etched film show that the side walls of the metal lines had undesirably rough and rippled surfaces. We presume this roughness is due to neodymium or $NdCl_3$ material remaining on the film after etching.

Comparative Example — Invention

We tested our process by etching 300 x 350 mm glass substrates on which a Al-Nd metal film had been deposited consisting of 88% aluminum, 10% silicon, and either 1% or 2% neodymium by weight. Because the 2% Nd film presented a more challenging test than the 1% Nd film tested in the Control described above, Table 1 only shows the results for the 2% Nd film. However, the test results also were successful with the 1 % Nd film.

Various combinations of chamber pressure, flow rates of HI and chlorine, and RF power were tested as detailed in Table 1. In all tests, the plasma was capacitively excited by the stated RF power at a frequency of 13 MHz. The flow rate of $BCl_3$ was 50 sccm, in all tests except Run 11, in which it was only 15 sccm. The metal film was etched to endpoint as indicated by a 3960 Å optical endpoint detector, and then over-etched for 90 seconds. Also, in all tests the substrate was initially sputter etched by $BCl_3$ for 1 minute before the $Cl_2$ and HI were turned on, for the purpose of removing native oxide from the metal film. (Run 1 was slightly different, as 10 sccm of $Cl_2$ was supplied during the initial sputter etch, which was conducted for 2 minutes.)

All combinations of test parameters etched the aluminum-neodymium film with excellent results, with the following exceptions: Run 2 exhibited metal features having a small amount of surface roughness due to residue. Run 12 exhibited some pitting in the side walls of the metal features.

Run 11 was the only run that exhibited corrosion after exposure to atmosphere. We believe this corrosion was due to the $BCl_3$ flow rate being only 15 sccm during Run 11; it was 50 sccm in all other runs. As stated earlier, $BCl_3$ beneficially scavenges water vapor, so inadequate $BCl_3$ could result in water residue that promotes corrosion.

Other than the exceptions just noted, SEM photographs of each of the test substrates showed that the metal lines produced by our etch process had side walls that were smoothly and uniformly tapered and had smooth surfaces free of residue. Furthermore, we found that, after etching by our process, the metal films were free of corrosion after 72 hours exposure to ordinary (non clean room) atmosphere, evidencing an absence of chlorine-containing residue on the film. Therefore, no anticorrosion treatment should be required after performing our etch process.

Table 1 -

| Etching 2% Nd/Al with $HI/Cl_2/BCl_3$ | | | | | | |
|---|---|---|---|---|---|---|
| Run | $Cl_2$ (sccm) | HI (sccm) | Pressure (mT) | RF Power (kW) | Etch Rate (Å/min.) | Etch Uniformity |
| 1 | 50 | 50 | 7 | 2.0 | 333 | 25 % |
| 2 | 75 | 25 | 7 | 2.0 | 210 | 21 % |
| 3 | 25 | 75 | 7 | 2.0 | 421 | 47 % |
| 4 | 75 | 150 | 10.5 | 2.0 | 516 | 42 % |
| 5 | 50 | 50 | 15 | 2.0 | 320 | 40 % |
| 6 | 100 | 100 | 15 | 2.0 | 356 | 47 % |
| 7 | 100 | 100 | 15 | 2.5 | 470 | 59 % |
| 8 | 50 | 50 | 7 | 2.5 | 533 | 40 % |
| 9 | 60 | 140 | 15 | 2.5 | 551 | 52 % |
| 10 | 60 | 140 | 15 | 2.5 | 640 | 52 % |
| 11 | 60 | 140 | 15 | 2.5 | 592 | 33 % |
| 12 | 60 | 140 | 30 | 2.5 | 457 | 26 % |
| 13 | 100 | 140 | 15 | 2.5 | 532 | 32 % |
| 14 | 75 | 75 | 8 | 2.0 | 422 | 31 % |
| 15 | 130 | 70 | 8 | 2.0 | 365 | 27 % |

**Claims**

1.  A method of etching an aluminum-neodymium alloy, the method comprising the steps of:

    providing a vacuum chamber that encloses an interior;
    positioning within the interior of the vacuum chamber a workpiece having at least one exposed region composed of an alloy of aluminium and neodymium;
    supplying gases into the interior of the chamber, wherein said gases include chlorine and hydrogen iodide; and
    coupling energy to the gas mixture so as to form a plasma body adjacent the workpiece.

2.  A method according to claim 1, wherein the supplying step comprises supplying the hydrogen iodide in the gas mixture in a proportion that is high enough to achieve removal of substantially all neodymium species from any areas of the alloy from which substantially all of the aluminum is removed.

3.  A method according to claim 1 or claim 2, wherein the supplying step further comprises adjusting the ratio between the flow rate of the chlorine and the flow rate of the hydrogen iodide so that the aluminium and neodymium components of the alloy are etched at approximately the same rate.

4.  A method according to any one of claims 1 to 3, wherein the supplying step further comprises adjusting the ratio between the volumetric flow rate of the chlorine and the volumetric flow rate of the hydrogen iodide in the range of 1:3 to 3:1.

5.  A method according to any one of claims 1 to 4, wherein the supplying step further comprises supplying $BCl_3$ gas into the interior of the chamber.

**6.** A method according to any one of claims 1 to 5, further comprising the step of:

applying to a cathode electrode within the chamber a negative voltage relative to an adjacent portion of the plasma body;
wherein the positioning step further comprises positioning the workpiece directly adjacent the cathode electrode, between the cathode electrode and said adjacent portion of the plasma body.

**7.** An apparatus for etching an aluminium-neodymium alloy on a workpiece, the apparatus comprising:

a vacuum chamber that encloses an interior;
a workpiece support member adapted for holding said workpiece at a position within the interior of the chamber;
a first container containing chlorine gas;
a second container containing hydrogen iodide gas;
a first flow controller, coupled between the first container and the interior of the chamber, for regulating a flow of chlorine gas from the first container to the chamber interior;
a second flow controller, coupled between the second container and the interior of the chamber, for regulating a flow of hydrogen iodide gas from the second container to the chamber interior, and
an energy source coupled to supply to the gases within the chamber interior sufficient energy to form a plasma body.

**8.** An apparatus according to claim 7, further comprising:
a master controller that commands the first and second flow controllers to maintain a ratio between the hydrogen iodide flow rate and the chlorine flow rate that is high enough to achieve removal of substantially all neodymium species from any areas of the alloy from which substantially all of the aluminium is removed.

**9.** An apparatus according to claim 7, further comprising:
a master controller that commands the first and second flow controllers to maintain a ratio between the hydrogen iodide flow rate and the chlorine flow rate so that the aluminium and neodymium components of the alloy are etched at approximately the same rate.

**10.** An apparatus according to any one of claims 7 to 9, further comprising:
a master controller that commands the first and second flow controllers to maintain a ratio between the hydrogen iodide flow rate and the chlorine flow rate that is in the range of 1:3 to 3:1, by volume.

**11.** An apparatus according to any one of claims 7 to 10, further comprising:

a third container containing $BCl_3$ gas; and
a third flow controller, coupled between the third container and the interior of the chamber, for regulating a flow of $BCl_3$ gas from the third container to the chamber interior.

**12.** An apparatus according to any one of claims 7 to 11, further comprising:

a cathode electrode positioned adjacent the workpiece position; and
an electrical power supply connected to the cathode electrode so as to apply to the cathode electrode a negative voltage relative to an adjacent portion of the plasma body.

*FIG._1*

*FIG._2*

*FIG._3*

*FIG._4*

*FIG._5*